# EUROPEAN PATENT APPLICATION

(11) **EP 0 837 503 A2**
(43) Date of publication of application: **22.04.1998**
(21) Application number: 97116499.1
(22) Date of filing: 22.09.1997
(51) Int. Cl.: H01L 23/522

(54) **Reference plane metallization on an integrated circuit**

(30) Priority: 16.10.1996 US 734436
(71) Applicant: DIGITAL EQUIPMENT CORPORATION, Maynard Massachusetts 01754-1418 (US)
(72) Inventor: Priore, Donald A., Maynard, Massachusetts 01754 (US)
(74) Representative: Betten & Resch

(57) **Abstract**

Integrated circuit signal inductance and cross talk is reduced by the use of dedicated patterned metallization layers as substantially continuous voltage reference planes. The voltage reference planes are either inserted between patterned metallization layers used for signal propagation, used as the top level of metal or the bottom level of metal. Two of the substantially continuous voltage reference planes may be placed adjacent to one another with no signal layer intervening to provide improved circuit power/ground impedance.

## Description

### BACKGROUND OF THE INVENTION

This invention relates generally to integrated circuits, and more particularly to the fabrication of integrated circuits that operate at high frequency and have multiple metallization layers of patterned conductors.

As is known in the art, complex integrated circuits fabricated on semiconducting substrates often require multiple layers of patterned conductors to interconnect various active elements provided upon the semiconductor substrate. In particular, in modern integrated circuits, multiple patterned conductor layers and associated dielectric spacing layers are alternately stacked upon one another in order to make connections between densely packed active elements such as transistors, resistors and capacitors.

Each of these patterned conductor layers is comprised of numerous individually electrically isolated patterned conductor lines. These patterned conductors carry signals such as data signals, clock timing pulses, power or ground voltage reference levels, to various portions of the integrated circuit. The signals on the patterned conductors may have interactions with other signals on other patterned conductors, either within the same metal layer, or in patterned conductors that are above or below the patterned conductor containing the signal. This is known in the art as inductive or capacitive coupling, commonly called cross talk. At low operating frequencies, while analysis and control of the inductive cross talk between signals within a given layer or between layers is not generally considered to be critical, capacitive coupling can be. As the operating frequencies of integrated circuits have increased, the need to model and to minimize, the inductive coupling between signals propagating on adjacent patterned conductors increases.

Another problem known in the art is that these patterned conductors are generally very thin and occasionally are relatively long. When a thin, long patterned conductor carries an electrical signal between two widely spaced active elements of the integrated circuit, a problem may exist with the resistance of the patterned conductor. In particular, patterned conductors that carry externally supplied power and ground reference values to various portions of the integrated circuit will have resistive voltage drops across the conductor due to the intrinsic resistance of the conductor. If the voltage drop is sufficiently high, different portions of the integrated circuit will be provided with different values of supply and reference potentials. In the prior art, such voltage drop problems were handled by placing very large and thick metal 'bus bars' traversing different portions of the integrated circuit to try to minimize the voltage drop from the edge of the integrated circuit to the middle of the integrated circuit. Generally these metal 'bus bar' patterned conductors were the top layer of metal, because if these conductors were in an intermediate level of metal, problems known in the art as "step coverage" problems with upper levels of metal may occur. Also generally, the upper layers of metal are thicker than the lower layers of metal, hence, there would be less resistance per unit area in a higher level metal than otherwise. Nevertheless, as the power consumption and speeds of integrated circuits have increased, there has existed a problem in the art to obtain consistent power and ground values at all portions of the silicon substrate.

Moreover, the use of such a 'bus bar' layer, is not an effective method for providing inductance control because the patterned conductor layer closest to the active devices in the circuit is separated, in a multilayer circuit, from the top 'bus bar' layer by numerous other patterned conductor layers. It is preferable to have the reference voltage closer to such a patterned conductor layer than is possible using 'meshes' or 'bus bar' lines in the top metal layer. Thus, while 'bus bars' provide an improvement to the voltage drop problem, it does not adequately address the problem of conductor inductive coupling. Further, the bus bar layer can only control the inductance of signals that are traveling in the same direction as the bus bar, and are directly beneath the bus bar. The prior art method of using bus bars to control inductance can only be used by designing the bus bars to travel directly above the signal line of interest, which introduces a new design constraint.

Thus, the prior art has two distinct problems with metallization layers. The first problem is that coupling between patterned conductors, particularly when the conductors run parallel to each other, may result in signal loss and spurious signals. The second problem is that voltage drops on power and reference lines connected between various portions of the integrated circuit can affect overall device performance.

### SUMMARY OF THE INVENTION

The invention, in its broad form, resides in an integrated circuit electrical device as recited in claim 1.

Described hereinafter is an integrated circuit electrical device includes a substrate having a plurality of devices arranged to provide an integrated circuit with a plurality of electrically conducting layers insulated from one another by at least one insulating layer. At least one of the plurality of electrically conducting layers is a first patterned electrically conductive layer, and at least one of the plurality of electrically conducting layers is a substantially continuous layer. With such an arrangement inductive coupling between parallel signals, both within the same patterned conductor layer and between different patterned conductor layers, is reduced with a concomitant increase in circuit speed and decrease in signal loss and spurious signals. Such an arrangement also provides improved uniform distribution of both power voltages and ground reference voltages to all portions of the integrated circuit.

### BRIEF DESCRIPTION OF THE DRAWINGS

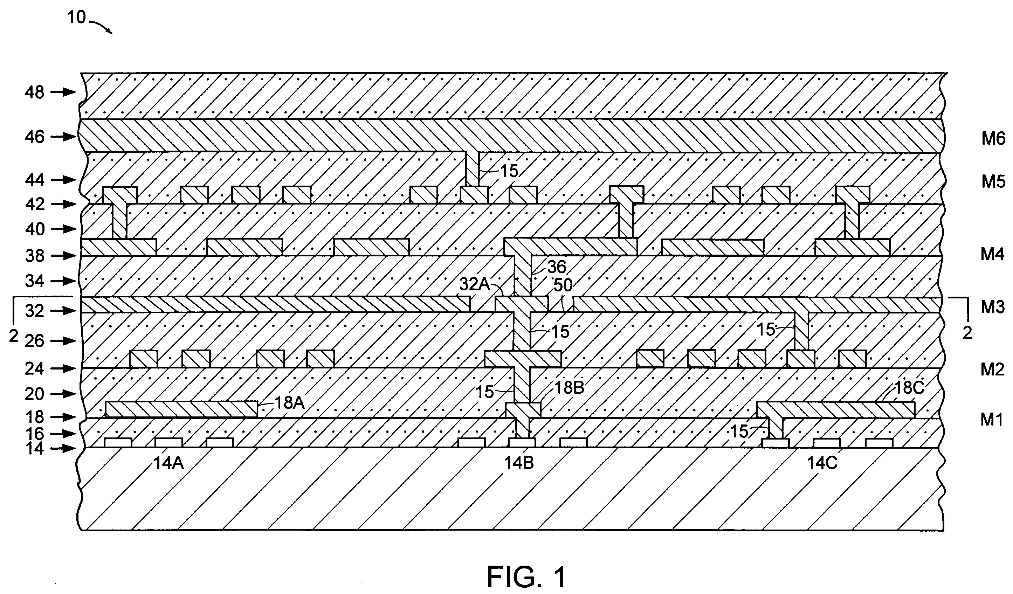

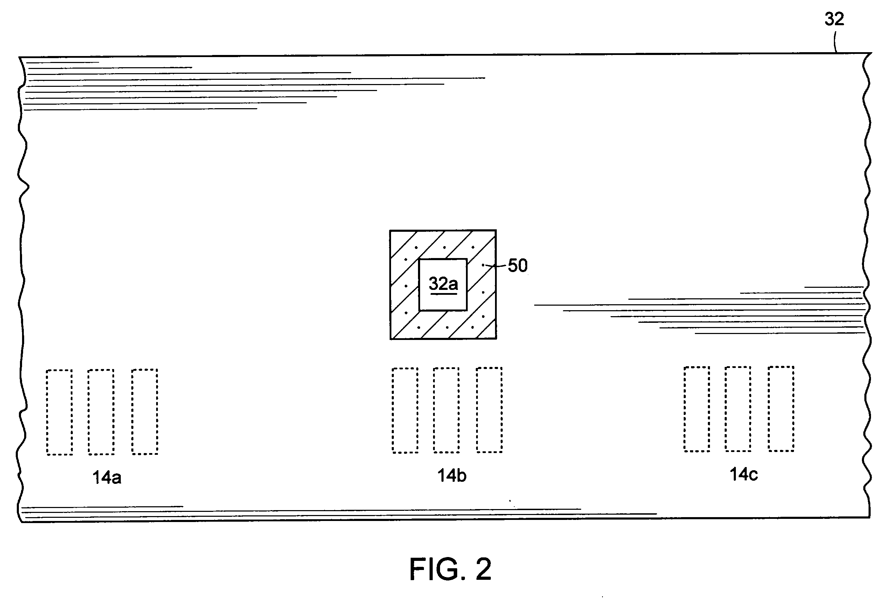

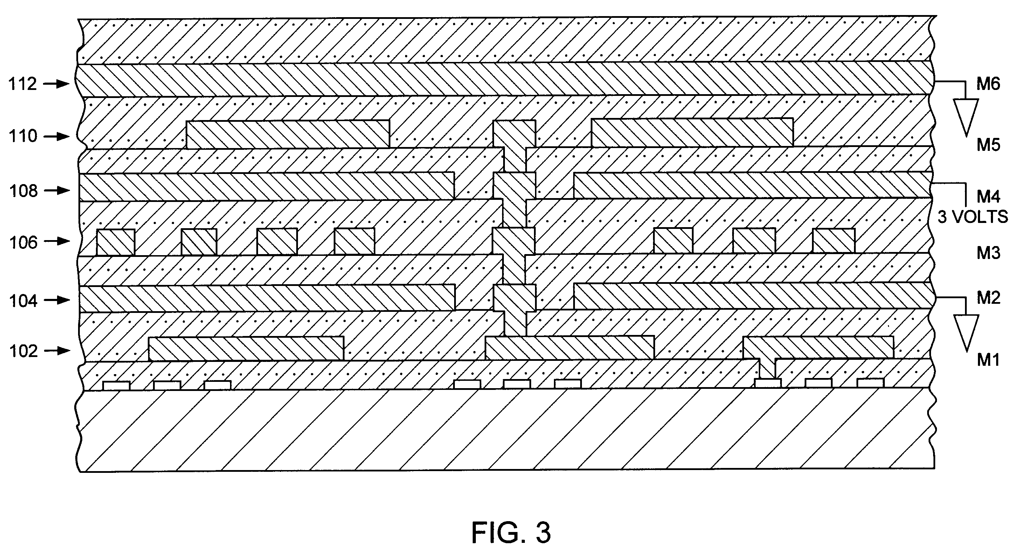

A more detailed understanding of the invention may be had from the following description of preferred embodiments given by way of example and to be understood in conjunction with the accompanying drawings wherein:
◆ FIG. 1 is a cross-sectional view of an integrated circuit having six interconnect layers;
◆ FIG. 2 is a plan view of the integrated circuit in FIG. 1 showing a third one of the interconnection layers and a via between a second one of the interconnection layers of metal and a fourth one of the interconnections; and
◆ FIG. 3 is a cross-sectional view of an alternative embodiment of an integrated circuit having three signal interconnect layers separated by three interleaved voltage reference layers.

### DESCRIPTION OF THE PREFERRED EMBODIMENT

Referring now to FIG. 1, an integrated circuit 10 includes a semiconducting substrate 12 which contains active semiconductor devices 14a-14c covered by dielectric layer 16. The active semiconductor devices are here intended to represent any integrated circuit active-type functions such as an analog or digital device. In particular, these devices are intended to represent a high performance digital device such as a high speed microprocessor, controller or memory device. Other types of devices could also benefit from the arrangement to be described. As illustrated, integrated circuit 10 is a microprocessor. Dielectric layer 16 and preferably, all dielectric layers to be described are planarized by any of the methods well known in the art, such as chemical mechanical polishing. Disposed over dielectric layer 16 is a first patterned conductor metal layer 18, which has individual strip conductors 18a-18c shown making contact to two of the active electronic devices, 14b and 14c through the dielectric layer 16 by vias 15. Metal layer 18 is insulated from succeeding metal layer 24 by a layer 20 of dielectric material as is well known in the art, and is interconnected with the other metal layer 24 by via holes 15 through the dielectric layer 20 as shown. Disposed over dielectric 26 is a reference plane metallization layer 32, dielectric layer 34, third patterned conductor layer 38 and dielectric layer 40. A fourth patterned metal layer 42 and associated dielectric layer 44 are disposed over dielectric layer 40. Here the final metal layer 46 is shown as being a reference plane metallization as was layer 32, and disposed on layer 46 is a passivation layer 48.

In general, all of the patterned conductors within a single metal layer are arranged to run parallel to one another for ease of lay out and design. However the signals within the patterned conductors are susceptible to inductive coupling because they are parallel. The patterned conductors in the first layer generally run from left to right (i.e., the X direction). In general, the second layer of patterned conductors 24 will also have most of the patterned conductors running in one direction, but the direction will be orthogonal to that of the first metal layer. This is done to minimize inter-layer coupling and for physical manufacturing purposes such as ease of signal routing. As a result of the orthoganality of the conductor direction in the metal layers, there is little inductive coupling between the patterned conductors of the two layers since the direction of current flow in the conductors of the two layers is at right angles and not parallel. However, the third layer patterned conductor 38 has patterned conductors generally oriented in the same direction as those of the first patterned conductor layer 18, and inductive coupling between signals in patterned conductor layer 18 and 38 may have to be considered, but is not very significant because of the greater separation between layers 18 and 38.

Metal layer 24, is insulated from the upper levels of metal by dielectric layer 26, which is preferably planarized by any of the well known methods known in the art. Dielectric layer 26 has via holes generally denoted as 15 by which the second patterned conductor layer 24 can either contact the third patterned conductor layer 32, or pass through the patterned conductor layer 32 and dielectric layer 34 through a via hole 36 to contact the patterned conductor layer 38.
Capacitive or inductive coupling (i.e., cross talk) either within a patterned conductive layer or between parallel pattern conductive layers such as the first and third layers 18 and 32, can cause signals loss, or unintended signals to propagate throughout the device as mentioned. Such interaction also slows down the device data signals and makes mathematical modeling of circuit behavior much more complex. As a result of the cross-talk between parallel patterned conductors, and the subsequent introduction of unintended signals or signal loss and decreased operating frequency, the performance of the integrated circuit may be degraded.

Still referring to FIG. 1, the third metal layer 32 is a substantially continuous reference metal plane. Metal layer 32 will have gaps such as 50 where a connection is needed between metal layers above and below that of the metal plane layer 32. Metal 38 is shown oriented in the same direction as the first metal 18. However, with the present arrangement, there is practically no inductive coupling between patterned conductor 38 and pattern conductor 18 signals despite the parallel patterned conductors, because conductive layer 32 is a substantially continuous metal layer that is either connected to ground or to power. Conductor layer 32 shields the parallel patterned conductors of the metal layers above and below metal 32 from inductive coupling and reduces inductive coupling between signals within a layer as well.

Likewise, continuous conductive layer 46 is a substantially continuous voltage reference plane similar to layer 32, and may be connected to the underlying patterned layers by via holes in dielectric layer 44 such as that shown at 15. Continuous conductive layer 46 is protected from scratches and contamination by a final dielectric layer 48, known in the art as 'passivation'.

As illustrated, the third continuous conductive layer 32, and the sixth continuous conductive layer 46, can be either both ground, or both power, or one power and one ground as desired by the designer and as appropriate for the particular circuit. When compared to the prior art it can be seen that the substantially continuous metal planes control the impedance and minimize cross-talk between signals in patterned layer 18, and patterned layer 38. The cross-talk or impedance problems between those two signals are suppressed by the substantially solid ground plane of continuous conductive layer 32. Equally, signals within patterned conductor layer 38 have reduced cross-talk with each other because there is a reference plane 32 that is close to signals carried by each individual patterned conductor. This is true irrespective of whether continuous conductive layer 32 is a ground or power plane, or whether continuous conductive layer 32 and continuous conductive layer 46 are of the same or of opposite polarity. Accordingly, a low resistance power and ground connection is provided all over the integrated circuit. In addition, modeling the circuit is simplified by the presence of the continuous conductive layers 32 and 46.

Another advantage of the current arrangement is that reduced inductive coupling between signal lines is provided. The low inductive coupling between patterned layers separated by the reference planes, plus that signals in patterned layer 24 have greater interactions with conductive layer 32 rather than with other patterned conductors within patterned layer 24, results in minimized cross-talk between signals, whether inter layer or intra layer.

For the purposes of this invention, a continuously conductive layer can be continuous as layer 46 for instance, or may be provided with gaps therein to allow electrical connections.

An additional benefit of the current arrangement as shown in FIG. 1 is that if layer 32 is the power reference layer, and layer 46 is the ground reference layer, then a lowered "power loop inductance" is generally provided. That is the use of two planes may reduce the overall circuit power/ground inductance substantially. The signal/reference inductance may be reduced to only one-third to one-half of that found in the prior art approach.

Referring now to FIG 2, the three active electronic devices 14a-c are shown (in phantom), as well as the substantially solid voltage reference plane 32. Dielectric filled area 50 separates the plane 32 into two electrically isolated regions, 32 and 32a. The region 32a is here a part of a conductive via that connects layer 24 to layer 38 (as was shown in FIG. 1). Thus metal region 32a connects the second and fourth layers of metal with out making contact to the third layer of metal voltage reference plane. This is known in the art as a via with a surround.

Referring now to FIG 3, an alternative embodiment of the present invention having interleaved signal patterned electrical conductive layers alternating with voltage reference planes. The signal patterned electrical conductive layers are herein shown for purposes of example as first patterned layer 102, third patterned layer 106 and fifth patterned layer 110. The voltage reference planes are herein shown for purposes of example as second continuous layer 104 connected to a ground voltage reference source, fourth continuous layer 108 connected to a 3 volt power reference source, and sixth continuous layer 112, also herein shown for example as connected to a ground voltage reference source. It should be noted that the voltage reference planes can individually be connected to either power or to ground independently of the other voltage reference planes.

It should also be noted that continuous layers for voltage reference planes may be placed in adjacent levels without a patterned electrical conductive layer disposed therebetween for purposes of improving the ground/power loop inductance. Further, single voltage reference continuous layers may be used as the upper most layer, or as the lower most layer, or both, for purposes of field shielding and inductance control.

Thus, in accordance with the invention, the insertion of a dedicated substantially continuous reference metal plane between the patterned conductor layers results in improved capacitive, resistive and inductive control of integrated circuits. In addition, the use of two reference planes of different polarity provides an improved loop path resulting in much simpler modeling for design of integrated circuits.

It should also be appreciated that other arrangements could be used. For example, a substantially continuous reference plane can be disposed above and below each layer of patterned conductors to provide a wave guide-like structure and to more completely shield individual signals from inductive coupling and cross talk.

It is generally known in the art that a transmission line has a controlled impedance generally referred to as a characteristic impedance which is related to the specific shape of the signal carrying conductor and its relationship to its return conductor. In addition, the characteristic impedance of a transmission line is related to the material properties of surrounding dielectric material. By providing continuous conductors closer to actual signal lines, a more controlled impedance environment is provided to the integrated circuit since coupling of spurious signals is reduced by the presence of the continuous conductors. This arrangement therefore, makes the signal lines more like transmission lines and therefore improves signal propagation.

Having described a preferred embodiment of the invention, it will now be apparent to one of skill in the art that other embodiments incorporating its concept may be used. It is felt, therefore, that this invention should not be limited to the disclosed embodiment.

## Claims

1. An integrated circuit electrical device, comprising:
a substrate having a pair of opposing surfaces, having over a first surface a plurality of devices arranged to provide an integrated circuit;
a plurality of electrically conducting layers insulated from one another by at least one insulating layer;
with at least one of said plurality of electrically conducting layers being a first patterned electrically conducting layer;
with at least one of said plurality of electrically conducting layers being a substantially continuous layer, said integrated circuit electrical device including a third one of said plurality of electrically conducting layers which is a second patterned electrically conducting layer and wherein said at least one substantially continuous layer is disposed between said first and second patterned electrically conductive layers, thereby minimizing effects of coupling between said first and second patterned electrically conducting layers.

2. The device of claim 1 wherein said at least one substantially continuous layer has gaps therein to allow electrical connections between said first and second patterned electrically conductive layers.

3. The device of claim 2 wherein said first and second patterned electrically conductive layers are disposed below said substantially continuous layer, and a fourth one of said plurality of electrically conductive layers is a third patterned layer and is disposed above said substantially continuous layer.

4. An integrated circuit electrical device comprising:
a substrate having a pair of opposing surfaces, having over a first surface a plurality of devices arranged to provide an integrated circuit;
a first plurality of patterned electrically conductive layers insulated from one another by a second plurality of insulating layers;
a first substantially continuous voltage reference layer disposed between two of said first plurality of patterned electrically conductive layers, and electrically isolated from said two patterned layers by a pair of said second plurality of insulating layers; and
a second substantially continuous voltage reference layer disposed between a different two of said first plurality of patterned electrically conductive layers, and electrically isolated from said different two of said patterned layers by a different pair of said second plurality of insulating layers.

5. The device of claim 4 wherein each said substantially continuous voltage reference layers has gaps therein to allow electrical connections between said two of said first plurality of patterned electrically conductive layers.

6. The device of claim 5 wherein two of said plurality of patterned electrically conductive layers are below said first substantially continuous voltage reference layer and at least one of said plurality of patterned electrically conductive layers is above said first substantially conductive voltage reference layer.

7. An electrical device comprising:
a substrate having a pair of opposing surfaces, having over a first surface a plurality of devices arranged to provide an integrated circuit;
a first plurality of patterned electrically conductive layers insulated from one another by a second plurality of insulating layers; and
a third plurality of substantially continuous voltage reference layers each disposed between a different two of said first plurality of patterned electrically conductive layers and insulated from said first plurality by at least one of said second plurality of insulating layers.
